Europäisches Patentamt

European Patent Office

Office européen des brevets

(11) Publication number: **0 188 329**
**B1**

## EUROPEAN PATENT SPECIFICATION

(45) Date of publication of patent specification: **05.09.90**

(21) Application number: **86300099.8**

(22) Date of filing: **08.01.86**

(51) Int. Cl.⁵: **H 03 F 3/24,** H 03 F 3/217,
H 03 F 1/06

(54) **AM signal transmitter.**

(30) Priority: **09.01.85 JP 1956/85**

(43) Date of publication of application:
**23.07.86 Bulletin 86/30**

(45) Publication of the grant of the patent:
**05.09.90 Bulletin 90/36**

(84) Designated Contracting States:
**CH DE FR GB LI**

(56) References cited:
**EP-A-0 054 981
US-A-2 235 549
US-A-3 435 378**

(73) Proprietor: **NEC CORPORATION
7-1, Shiba 5-chome Minato-ku
Tokyo 108-01 (JP)**

(72) Inventor: **Kobayashi, Naoki c/o NEC
Corporation
33-1 Shiba, 5-chome Minato-ku
Tokyo (JP)**
Inventor: **Asakura, Takashi c/o NEC Corporation
33-1 Shiba, 5-chome Minato-ku
Tokyo (JP)**
Inventor: **Sato, Hideo c/o NEC Corporation
33-1 Shiba, 5-chome Minato-ku
Tokyo (JP)**

(74) Representative: **Pears, David Ashley et al
REDDIE & GROSE 16 Theobalds Road
London WC1X 8PL (GB)**

Courier Press, Leamington Spa, England.

## Description

The present invention relates to a transmitter for an amplitude modulated signal and more particularly, an AM signal transmitter provided with a pulse width modulation system.

In a high power AM signal transmitter, it is an important requirement to improve the power efficiency as much as possible, and, to this end, class D amplification or pulse width modulation is utilized. One known AM transmitter comprises a modulation amplifier and a modulated power amplifier of the final stage connected in series, the modulation amplifier being subject to pulse operation by a pulse width modulated signal. Another prior art AM transmitter is disclosed in UK Patent Application GB-A-2,079,105, whose modulation amplifier section is structured in a push-pull arrangement. However, in the prior art AM transmitters, the power supply source has to have a voltage about twice that needed for operating the power amplifier of the final stage. Therefore, this leads to disadvantages of a high cost and greater danger derived from the higher voltage.

An object of the present invention, according to Claims 1 and 5 therefore, is to provide an AM signal transmitter which does not require a higher power supply source voltage than a voltage for driving the power amplifier circuit at the final stage.

Another object of the present invention is to provide an AM signal transmitter in which a common power supply source can be used for the modulation amplifier stage and the power amplifier stage, resulting in reduction of a production cost.

The AM signal transmitter according to the invention is defined in the appended claims.

The invention will be described in more detail, by way of example, and with reference to the accompanying drawings, in which:

FIGS. 1(a) and 1(b) illustrate circuit configurations of serial pulse width modulated transmitters according to the prior art;

FIG. 2 shows a block diagram of one preferred embodiment according to the present invention; and

FIGS. 3(A), 3(B), 3(C), 3(D), 3(E) and 3(F) show waveforms to illustrate the operation of the preferred embodiment of the invention shown in FIG. 2.

Description of the Prior Art

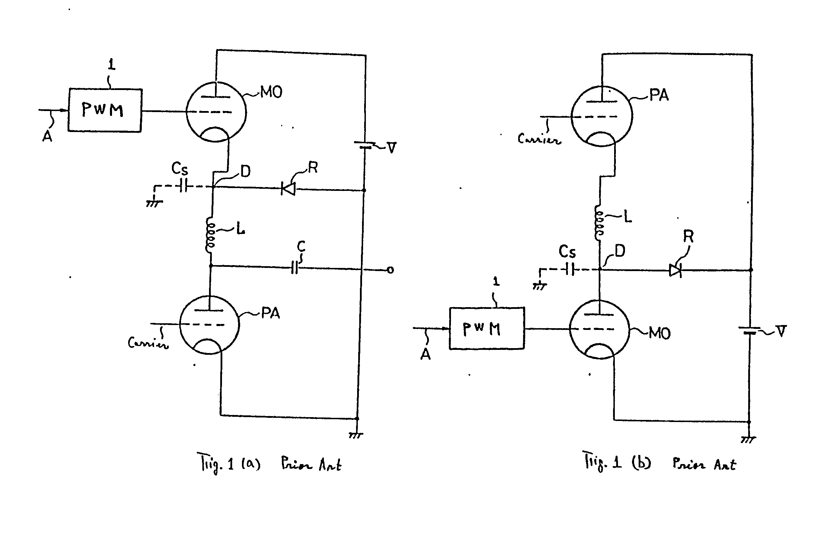

First the prior art will be described with reference to FIGS. 1(a) and 1(b), which are pulse width modulated transmitters. In a prior art high power serial pulse width modulation transmitter as illustrated in FIG. 1(a), a modulation amplifier MO, which is turned on and off by the output of a pulse with modulator 1, and a modulated power amplifier PA, which is turned on and off by a high frequency carrier signal, are connected in series to a power supply source V through an inductance L.

Thus, the anode of the modulation amplifier MO is connected to the positive side of the power supply source V; the cathode thereof is connected to the anode of the modulated amplifier PA through the inductance L; the cathode of the modulated amplifier PA is connected to the negative side (ground) of the power supply source V; and the cathode of the modulation amplifier MO is connected by a diode R to the negative side of the power supply source V. The modulated carrier signal is output from the anode of the modulated amplifier P through a capacitor C.

The circuit configuration described above is capable of amplitude modulation with a high power and high efficiency by switching on and off the modulation amplifier MO at pulse widths proportional to the amplitudes of a low frequency signal (an audio signal) A and by accumulating energy into the inductance L while the modulation amplifier MO is on. However, this circuit configuration of the prior art has a disadvantage that modulation distortion occurs and the efficiency is lowered, by a stray capacitance $C_S$ presented between a filament of the modulation amplifier MO, i.e., the point D and ground. A greater part of the stray capacitance $C_S$ is attributable to the stray capacitance of a filament transformer, and therefore it is difficult to eliminate. To overcome this disadvantage, there is another circuit configuration as shown in Fig. 1(b) wherein the stray capacitance $C_S$ at the output point D of the modulation amplifier MO is decreased by grounding the filament side thereof and the modulated amplifier PA is connected to the positive side of the power supply source V. But, in this case, the cathode of the modulated amplifier PA is floating from the ground, and this is undesirable for stable operation which is required of a high power transmitter.

Both of the prior art circuits described above still have a disadvantage that the voltage of the power supply source V has to be double the voltage normally needed to operate the modulated power amplifier PA. This not only makes the system more expensive but leads to less stability and more danger. Moreover, since vacuum tubes, which are susceptible to frequent troubles, are connected in series through the inductance L, the modulation amplifier MO may be destroyed by a transient voltage impressed on it in the event of a failure of the modulated power amplifier PA. Preventing this would require an elaborate device.

There is another disadvantage that, especially in 100% modulation, whereas the width of the output pulse of the pulse width modulator 1 becomes zero corresponding to the troughs of the low frequency signal, audible distortion may be induced by the stray capacity $C_S$. Furthermore, the modulation amplifier MO has to be active when the modulated power amplifier PA is to be initially regulated.

The power consumed in the modulation amplifier MO corresponds to a carrier component plus a side band component, and therefore it requires a capacity at least equal to that of the modulated power amplifier PA. Furthermore, when the modulation amplifier MO is cut off, the diode R is made conductive, so that the diode should have a enough capacity to withstand the voltage and a peak current, which are applied to the modulation amplifier M0.

The other prior art transmitter disclosed in UK Patent Application GB-A-2,079,105 is free from such disadvantages of the transmitters shown in FIGS. 1(a) and 1(b). However, this transmitter still has the disadvantage that the voltage of the power supply source for the modulation amplifier stage is double that for the modulated power amplifier of the final stage. Therefore, two independent power supply sources are needed and the higher voltage should be unavoidably treated.

Preferred Embodiment of the Invention

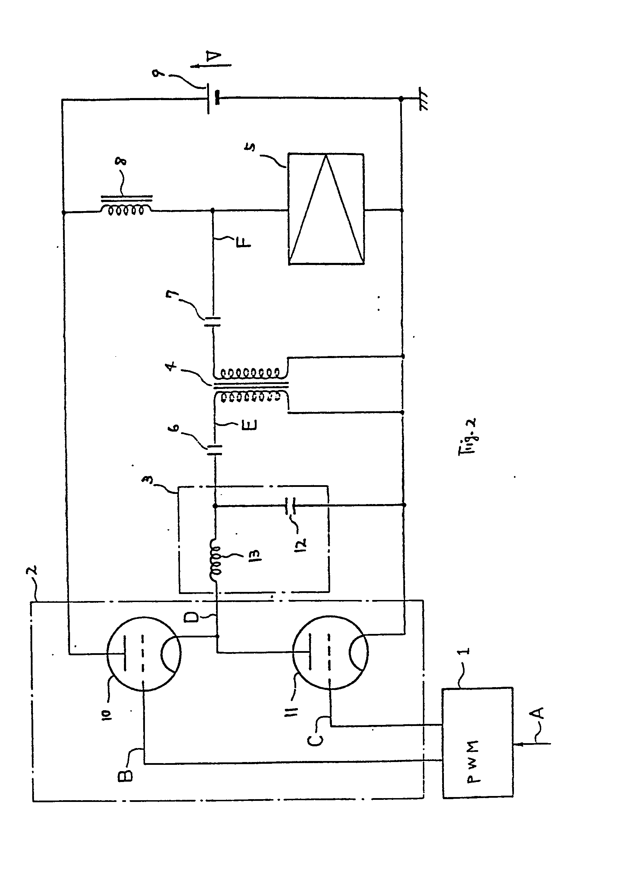

FIG. 2 is a circuit diagram illustrating one preferred embodiment of the present invention. The embodiment comprises a pulse width modulator 1 for modulating a pulse width in accordance with an amplitude of a low frequency signal (an audio signal) A, a modulation amplifier 2 for amplifying the output of the pulse width modulator 1, a low pass filter 3 for accumulating the output of the modulation amplifier 2, a low frequency transformer 4 for raising the voltage of the output delivered from the low pass filter 3, and a modulated power amplifier 5 whose driving DC voltage is increased and decreased in response to the output of the low frequency transformer 4. Furthermore, this figure contains coupling capacitors 6 and 7, a modulation choke coil 8, and a common power supply source 9.

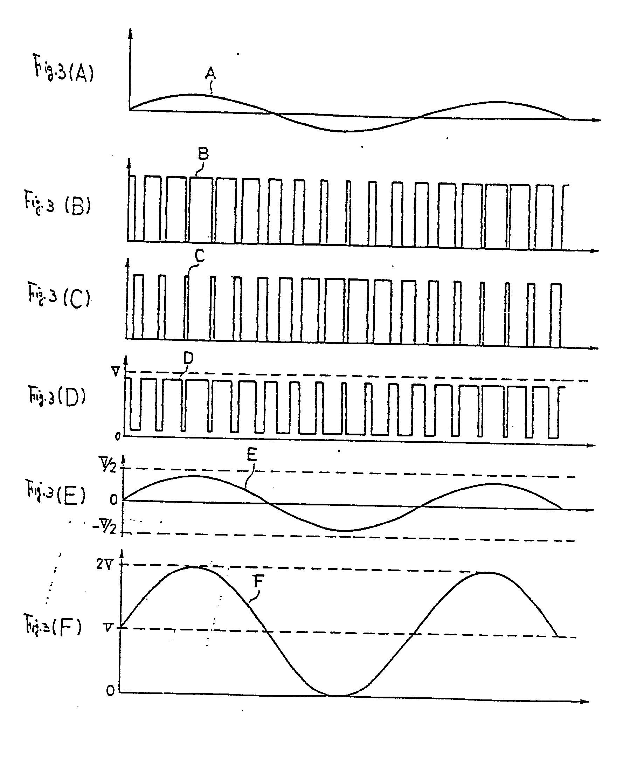

The low frequency signal, represented by FIG. 3(A), is fed to the pulse width modulator 1. Modulated pulse trains B and C, respectively represented by FIG. 3(B) and 3(C), are produced by the pulse width modulator 1. The pulse train B consists of pulses having a shorter pitch than the pitch of the highest frequency of the low frequency signal A, and widths corresponds to the instantaneous magnitude of the low frequency signal A. Further, the pulse width reaches its minimum (not zero) for the trough of the low frequency signals A and its maximum (slightly narrower than the pulse pitch), i.e., approximately half the pulse pitch for the peak. The pulse train C is reverse to the pulse train B in polarity. In the prior art AM transmitter, when 100% modulation is achieved, the pulse width at the trough of the low frequency signal is set to zero and the pulse width at the peak is set to the pulse pitch. But, according to the present invention, to reduce the undesirable influence of the stray capacity as stated above, the non-zero narrow pulse width at the trough of the low frequency signals A and the pulse width slightly narrower than the pulse pitch at the peak are applied.

In the modulation amplifier 2, switching elements 10 and 11, together constituting a push-pull arrangement, are composed of vacuum tubes or semiconductor elements. The switching element 10 is turned on and off in response to the high and low levels of the pulse train B respectively, while the switching element 11 is turned on and off in response to the high and low levels of the pulse train C respectively. Therefore, the switching elements 10 and 11 are turned on and off in a mutually complementary manner. When the switching element 10 is turned on, the voltage of an output D of the modulation amplifier 2 is slightly lower than the voltage V of the power supply source 9, and when the switching element 11 is turned on, the voltage of the output D is slightly higher than zero. Consequently, the voltage waveform of the output D of the modulation amplifier 2 is such as shown in FIG. 3(D). Since the DC component of the output voltage of the low pass filter 3 is removed by the coupling capacitor 6, an input voltage waveform to the low frequency transformer 4 becomes as shown in FIG. 3(E), having a peak-to-peak V(1-α) AC voltage. This is an amplified signal of the low frequency signals A. Incidentally, in order to completely eliminate a pulse frequency component, it is desirable to connect a capacitor 12 between the output side of an inductance 13 and the ground. Further, the combination of the inductor 12 and a capacitor 13 in the low pass filter 3 may as well be connected in multiple stages.

In this embodiment, if the transformation ratio of the low frequency transformer 4 is set to (1-α):2, the maximum level of the output waveform at the transformer's secondary winding will be exactly V(2 V peak to peak). The voltage-raised output waveform is added to the source voltage V supplied through the modulation choke coil 8 and the added voltage is supplied to the modulated power amplifier 5. The added voltage F supplied to the modulated power amplifier 5 varies between 2 V and 0 centering around the source voltage V as shown in FIG. 3(F), when the input low frequency signal A has a magnitude for the maximum modulation. Therefore, in this case, the modulated power amplifier 5 can produce an AM carrier 100% modulated.

In the embodiment, since the modulation amplifier 2 does not treat the carrier, its average power consumption is saved, and it is sufficient to use two elements whose capacity is only a quarter of that of the prior art configuration shown in Figs. 1(a) and 1(b). Therefore, the transmitter can be readily reduced in dimensions, cost, and the stray capacity. In the low pass filter 3, no DC current flows, but only the low frequency signal does. This feature contributes to the reduction of size and cost of the low pass filter 3. In comparison with the prior art transmitters shown in Figs. 1(c) and 1(b), this embodiment needs no diode for supplying large peak current when the modulation amplifier is cut off.

As hitherto described, the present invention enables an AM transmitter to be operated by a common power supply source having a voltage no more than half that is required in prior art transmitters.

Furthermore, the present invention can reduce the size and the number of constituent elements in a transmitter.

## Claims

1. An amplitude modulated signal transmitter, comprising pulse width modulating means (1) for modulating the pulse width of high frequency pulse train in response to an input modulating signal (A) to produce a pulse width modulated signal; modulation amplifying means (2) for amplifying the pulse width modulated signal; filtering means (3) for filtering the amplified pulse width modulated signal; and a power amplifier (5) for amplifying an input carrier to generate an amplitude-modulated carrier, the voltage for operating the power amplifier being controlled in response to the filtered signal, characterised by a voltage step-up transformer means (4) coupled between the filtering means (3) and the power amplifier (5).

2. A transmitter as claimed in claim 1, characterised by a common power supply source (9) providing power to both the modulation amplifying means (2) and the power amplifier (5).

3. A transmitter as claimed in claim 1 or 2, characterised in that the modulation amplifying means (2) includes two switching elements (10, 11) which are connected in series and operate in push-pull manner.

4. A transmitter as claimed in claim 1, 2 or 3, characterised in that the transformer means (4) has a step-up ratio of at least 2.

5. An amplitude modulated signal transmitter for generating an amplitude-modulated carrier, comprising a power supply source (9), modulation amplifying means (2) supplied by the power supply source for amplifying a pulse width modulated signal, filtering means (3) for low-pass filtering the amplified pulse width modulated signal, and a power amplifier (5) for amplifying an input carrier to generate the amplitude-modulated carrier, the power amplifying means being connected to the power supply source (9) through an inductance coil (8), characterised by a voltage step-up transformer means (4) coupled between the filtering means (3) and to a point between the power amplifier (5) and the inductance coil (8).

## Patentansprüche

1. Amplitudenmodulation-Signalsender mit Pulsbreiten-Modulationseinrichtungen (1) zum Modulieren der Pulsbreite einer Hochfrequenz in Pulsfolge in Abhängigkeit von einem Eingangsmodulationssignal (A), so daß ein pulsbreitenmoduliertes Signal erzeugt wird, Modulationsverstärkereinrichtung (2) zum Verstärken des pulsbreitenmodulierten Signals, Filtereinrichtungen (3) zum Filtern des verstärkten pulsbreitenmodulierten Signals und ein Leistungsverstärker (5) zum Verstärken eines Eingangsträgers, so daß ein amplitudenmodulierter Träger erzeugt wird, wobei die Spannung zum Betrieb des Leistungsverstärkers gesteuert wird in Abhängigkeit von dem gefilterten Signal, gekennzeichnet durch eine Einrichtung (4) zum Hochtransformieren einer Spannung die zwischen den Filtereinrichtungen (3) und dem Leistungsverstärker (5) angeschlossen ist.

2. Sender nach Anspruch 1, gekennzeichnet durch eine gemeinsame Leistungsversorgungsquelle (9), die Leistung sowohl an die Modulationsverstärkereinrichtung (2) als auch den Leistungsverstärker (5) liefert.

3. Sender nach Anspruch 1 oder 2, dadurch gekennzeichnet, daß die Modulationsverstärkereinrichtung (2) zwei Schaltelemente (10, II) aufweist, die in Serie miteinander verbunden sind und im Gegentakt arbeiten.

4. Sender nach Anspruch 1, 2 oder 3, dadurch gekennzeichnet, daß die Transformationseinrichtung (4) ein Aufwärtsverhältnis von mindestens 2 hat.

5. Amplitudenmodulation-Signalsender zum Erzeugen eines amplitudenmodulierten Trägers, mit einer Leistungsversorgungsquelle (9), Modulationsverstärkereinrichtung (2), die von der Leistungsversorgungsquelle beliefert wird zum Verstärken eines pulsbreitenmodulierten Signals, Filtereinrichtungen (3) zum Tiefpaßfiltern des verstärkten pulsbreitenmodulierten Signals und einen Leistungsverstärker (5) zum Verstärken eines Eingangsträgers, so daß der amplitudenmodulierte Träger erzeugt wird, wobei die Leistungsverstärkereinrichtung über eine Induktionsspule (8) mit der Leistungsversorgungsquelle (9) verbunden ist, gekennzeichnet durch eine Einrichtung (4) zum Hochtransformieren einer Spannung, die zwischen der Filtereinrichtung (3) und einem Punkt zwischen dem Leistungsverstärker (5) und der Induktionsspule (8) angeschlossen ist.

## Revendications

1. Emetteur de signal modulé en amplitude comprenant un moyen de modulation d'impulsions en largeur (1) pour moduler la largeur d'impulsion d'un train d'impulsions de haute fréquence en réponse à un signal d'entrée de modulation (A) pour produire un signal à modulation d'impulsions en largeur; un moyen d'amplification de modulation (2) pour amplifier le signal à modulation d'impulsions en largeur; un moyen de filtrage (3) pour filtrer le signal à modulation d'impulsions en largeur; et un amplificateur de puissance (5) pour amplifier une porteuse d'entrée pour produire une porteuse modulée en amplitude, la tension pour commander l'amplificateur de puissance étant commandée en réponse au signal filtré, caractérisé par un moyen de transformateur élévateur de tension (4) couplé entre le moyen de filtrage (3) et l'amplificateur de puissance (5).

2. Emetteur selon la revendication 1, caractérisé par une source de tension d'alimentation commune (9) fournissant la puissance à la fois au moyen d'amplification de modulation (2) et à l'amplificateur de puissance (5).

3. Emetteur selon la revendication 1 ou 2, caractérisé en ce que le moyen d'amplification de modulation (2) comprend deux éléments de commutation (10, 11) qui sont connectés en série et fonctionnent selon une manière symétrique.

4. Emetteur selon la revendication 1, 2 ou 3, caractérisé en ce que le moyen de transformateur (4) comporte un rapport d'élévation d'au moins 2.

5. Emetteur de signal modulé en amplitude pour produire une porteuse modulée en amplitude, comprenant une source d'alimentation (9), un moyen d'amplification de modulation (2) fourni par la source d'alimentation pour amplifier un signal à modulation d'impulsions en largeur, un moyen de filtrage (3) pour le filtrage passe-bas du signal amplifié à modulation d'impulsions en largeur, et un amplificateur de puissance (5) pour amplifier une porteuse d'entrée pour produire la porteuse modulée en amplitude, le moyen d'amplification de puissance étant connecté à la source d'alimentation (9) à travers une bobine d'inductance (8), caractérisé par un moyen de transformateur élévateur de tension (4) couplé entre le moyen de filtrage (3) et un point entre l'amplificateur de puissance (5) et la bobine d'inductance (8).

Fig. 1 (b) Prior Art

Fig. 1 (a) Prior Art

Fig. 2

EP 0 188 329 B1

Fig.3(A)

Fig.3 (B)

Fig.3 (C)

Fig.3 (D)

Fig.3 (E)

Fig.3 (F)